(19) **Europäisches Patentamt European Patent Office Office européen des brevets**

(11) **EP 3 750 197 B1**

(12) **EUROPEAN PATENT SPECIFICATION**

(45) Date of publication and mention of the grant of the patent:
**15.09.2021 Bulletin 2021/37**

(51) Int Cl.:
*H01L 41/04* *(2006.01)*     *H01L 41/193* *(2006.01)*
*H02N 11/00* *(2006.01)*

(21) Application number: **19701364.2**

(22) Date of filing: **29.01.2019**

(86) International application number:
**PCT/EP2019/052032**

(87) International publication number:
**WO 2019/154664 (15.08.2019 Gazette 2019/33)**

(54) **ACTUATOR DEVICE USING CURRENT-ADDRESSED ELECTROACTIVE POLYMER**

AKTUATORVORRICHTUNG MIT STROMADRESSIERTEM ELEKTROAKTIVEM POLYMER

DISPOSITIF D'ACTIONNEUR UTILISANT UN POLYMÈRE ÉLECTROACTIF PILOTÉ PAR COURANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.02.2018 EP 18156078**

(43) Date of publication of application:
**16.12.2020 Bulletin 2020/51**

(73) Proprietor: **Koninklijke Philips N.V.**
**5656 AE Eindhoven (NL)**

(72) Inventors:
• **JOHNSON, Mark, Thomas**
  **5656 AE Eindhoven (NL)**
• **FISH, David, Andrew**
  **5656 AE Eindhoven (NL)**

(74) Representative: **Philips Intellectual Property & Standards**
**High Tech Campus 5**
**5656 AE Eindhoven (NL)**

(56) References cited:
**WO-A1-2015/045605     WO-A1-2017/108489**
**JP-A- 2015 204 702**

## Description

FIELD OF THE INVENTION

This invention relates to actuator array devices which make use of electroactive polymers, in particular current-addressed electroactive polymers.

BACKGROUND OF THE INVENTION

Electroactive polymers (EAP) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0-20 kHz.

Devices using electroactive polymers can be subdivided into field-driven and ionic-driven materials.

Examples of field-driven EAPs are dielectric elastomers, electrostrictive polymers (such as PVDF based relaxor polymers or polyurethanes) and liquid crystal elastomers (LCE).

Examples of ionic-driven EAPs are conjugated polymers, carbon nanotube (CNT) polymer composites and Ionic Polymer Metal Composites (IPMC). Both classes have multiple family members, each having their own advantages and disadvantages.

From a technology perspective, typically, field-driven EAPs are actuated by an electric field through direct electromechanical coupling. In principle the field or voltage on electrodes to produce this field determines a state of actuation of a device. This can be called a voltage driven actuator device. On the other hand ionic EAPs, or at least a large subset of them, are examples of materials that can be called current-driven, i.e. they generally need an increased amount or sustained current to achieve and/or maintain a state of actuation. The corresponding actuators can be called current driven or current actuated actuators. The distinction between the two types is however not always all that clear. For example Voltage driven devices may be imperfect (due to example given leakage) and require a constant current to maintain an achieved state of actuation. Nevertheless, there are many EAPs of both types that need a switching and or sustained current for their accurate actuation and the current invention is beneficial for all such EAPs.

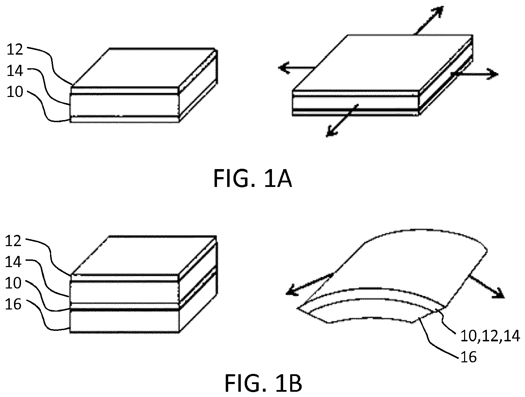

Figs. 1A and 1B show two possible operating modes for a general EAP device, which can be part of the currently disclosed devices. The device comprises an electroactive polymer layer 14 sandwiched between electrodes 10, 12 on opposite sides of the electroactive polymer layer 14. The electrodes are used for driving of the actuator. Fig. 1A shows a device which is not clamped. Depending on the type of EAP material used, a voltage or current is used to cause the electroactive polymer layer to expand in all directions as shown.

Fig. 1B shows a device which is designed so that the expansion arises only in one direction. The device is supported by a carrier layer 16. Again, depending on the type of EAP used, a voltage or current actuation signal is used to cause the electroactive polymer layer to curve or bow. The nature of this curving or bowing movement for example arises from the interaction between the active layer which expands when actuated, and the passive carrier layer which resists such expansion. To obtain the asymmetric curving around an axis as shown, molecular orientation (film stretching) may for example be applied, forcing the movement in one direction. The expansion in one direction may result from the asymmetry in the electroactive polymer, or it may result from asymmetry in the properties of the carrier layer, or a combination of both.

The fact that for switching and/or maintenance of actuation, currents are needed requires special measures for driving units (driving ICs) of such actuators. This is even more so when for certain applications multiple of such actuators are to be used, for example in actuator array devices that may be used for positioning systems or controlled topology surfaces. In such cases it quickly becomes expensive to drive each actuator individually with its own driver IC and individual actuation is not easy because of crosstalk.

While a passive matrix driving scheme as known from display technology can be a useful and simple implementation of an array driving system as it uses only row (n rows) and column (m columns) connections and thus only (n+m) drivers are required to address up to (n x m) actuators, in such arrays of traditional EAP actuators some cross talk to adjacent actuators will be present. When a signal is applied to actuate one actuator, the actuators around it also will partially actuate, which is an unwanted effect for many applications. Hence, with a passive matrix addressing scheme it is not straightforward to individually address each actuator independently of the others.

The use of an active matrix for addressing arrays of voltage driven electroactive polymer actuators has been proposed by the applicant in WO2017/108489 and WO2017/108443. This approach involves providing a switching device at each electroactive polymer actuator, at the intersection of a row conductor and a column conductor. In this way, each actuator in the array can - if desired - be individually actuated. An active matrix addressing scheme means it is possible to have any random pattern of actuators in the array actuated at the same time. This approach is however not suitable for driving EAPs in which current control as described herein above is required.

JP 2015-204702 shows a drive circuit for an ionic polymer actuator (i.e. current driven). There, an actuator unit (pixel) comprises a switching element, a drive element and an actuator.

WO 2015/045605 also shows drive circuits for electroactive polymer actuators with a series of switches (transistors) controlled via control lines an supplying voltages to actuators.

SUMMARY OF THE INVENTION

There remains a need for an approach which enables or improves active matrix addressing of electroactive polymer actuators that require a current for switching between actuation states and/or for maintaining of actuation states.

It is an object of a device and method according to the claims to address the aforementioned need. The object is at least partly achieved with the device and method of the claims. The dependent claims define advantageous embodiments.

According to the claims, there is provided an actuator device comprising:

> an active matrix array of current-driven electroactive polymer actuators;
> a set of addressing lines, with each electroactive polymer actuator associated with two addressing lines, for selecting the electroactive polymer actuator and a discharge or charge mode;
> a respective switching circuit associated with each electroactive polymer actuator, wherein each switching circuit comprises:
>
>> a first circuit comprising at least a first transistor for driving a controllable current through the electroactive polymer actuator in a first direction in response to a first addressing signal; and
>> a second circuit comprising at least a second transistor for driving a controllable current through the electroactive polymer actuator in an opposite, second direction in response to a second addressing signal.

The control line is controlling a gate of a drive transistor. The control line is thus suitable for providing driving data (gate control voltage) that determine a current to the actuator and for selection of an actuation mode. Thus, driving the actuator in the first direction may be called a charging mode while driving in the second direction may be called a discharging mode or vice versa. The control lines can be used to choose the sense of actuation.

This device enables an actuator to be driven with current in two opposite directions so that the actuator may be driven bidirectionally between states. The current can be used for switching between states and or/for maintaining of states. The device can thus work for current-driven and voltage driven actuators or hybrid type devices. It has its particular advantages for the current-driven actuators.

Also, the control lines can be used to select an actuator when there are multiple ones a device such as with an array of actuators.

The device avoids that upon change of direction of driving large high amounts of charge must be transported in driving conductors of the actuators. The addressing lines of the direction of current the charging of the drive. Such charging discharging of power lines and/or addressing lines can cause undesired time delays.

The first addressing signal may be during a first addressing period, and the second addressing signal may be during a second addressing period. In this context, the term "period" is just used to indicate different actuation commands at different times. The "period" is not necessarily the same for all actuators or indeed regular or periodic. When charging is required and when discharging is required will depend on the current actuation state and the next desired actuation state. Potentially, the charging and second circuits may be run together, for example if one of the circuits has only a few bits resolution and the other many more bits. In this way, the drive signal may be defined as a difference current between a charging current and a discharging current. This drive signal may be a signal to change the actuator state or it may be a sustain current.

The first and second transistors are preferably in series between first and second power lines, and the electroactive polymer actuator is connected to the junction between the first and second transistors. One transistor drives current into the actuator and the other transistor sinks current out of the actuator. Thus, the actuator is for example at a voltage between the power line voltages.

In a first set of examples:

> the first circuit comprises a first switch between a first data line and the gate of the first transistor and a storage capacitor for storing a voltage provided to the gate of the first transistor, the first switch being controlled by a first addressing line; and
the second circuit comprises a second switch between a second data line and the gate of the second transistor and a storage capacitor for storing a voltage provided to the gate of the second transistor, the second switch being controlled by a second addressing line.

This version makes use of two voltage driven circuits, so that the first and second data lines for example comprise voltage supply conductors.

Each transistor functions as a voltage to current converter, with its gate voltage determining the current flowing and the storage capacitor holding the gate voltage so that the desired current is maintained.

The first and second addressing lines may comprise row conductors and the first and second data lines may comprise column conductors. Thus, the first circuit and the second circuit each have a row (addressing) line and a column (data) line.

For the voltage-addressed implementation of this first set of examples, each switching circuit may further comprise:

> a first boost transistor in parallel with the first transistor;
> a second boost transistor in parallel with the second transistor; and
> an enable line for enabling or disabling the boost transistors.

These boost transistors enable the charging and discharging currents to be accurately controllable in two modes - one is a high current mode for implementing actuation level changes and the other is a low current mode for implementing a sustain function.

In a second set of examples:

> the first circuit comprises a first current mirror circuit including at least the first transistor and a reference transistor;
> the second circuit comprises a second current mirror circuit including at least the second transistor and said reference transistor; and
> the switching circuit further comprises:

>> a first switch between a data line and the reference transistor, the first switch being controlled by a first addressing line; and
>> a selection circuit for selecting the first or second current mirror circuit for mirroring a current sampled from the data line, under the control of a second addressing line.

In this set of examples, a current is provided to the actuator switching circuit, so that the data line preferably comprises a current supply conductor. Two current mirror circuits are formed; one for the first circuit and one for the second circuit. The selection of which current mirror circuit is used determines in which direction the actuator is controlled.

The first addressing line may comprise a row conductor and the data line and second addressing line each comprise a column conductor. For a selected row, one column conductor selects a charge or discharge mode and the other provides the current to be mirrored. Thus, each actuator needs only three conductors. Of course there may instead be two data lines and two addressing lines, so that the first circuit and the second circuit each comprise an address line and a data line.

The switching circuit for example comprises a storage capacitor for storing a voltage on the gate of the reference transistor in response to a current provided from the data line. This provides a current sample and hold function.

In all examples, the switching circuit for example comprises thin film transistors, for example low temperature polysilicon transistors.

The invention also provides a method of actuating a device which comprises an active matrix array of current-driven electroactive polymer actuators, wherein the method comprises:

> using a set of addressing lines to select a group of electroactive polymer actuators in a discharge or charge mode during different addressing periods;
> when driving an actuator in the charge mode, using a first circuit to drive a controllable current through the electroactive polymer actuator in a first direction in response to a first addressing signal; and
> when driving an actuator in the discharge mode, using a second circuit to drive a controllable current through the electroactive polymer actuator in an opposite, second direction in response to a second addressing signal.

The two addressing modes may be sequential. However, they may also be simultaneous, with the actual current delivered to (or drained from) the actuator being based on the difference between the charge and discharge currents.

The may further comprise operating the actuator in a sustain mode wherein a smaller current is provided than in the charge mode or discharge mode in order to sustain an actuation level.

In a first set of examples the method comprises:

> when driving in the charge mode, providing data from a first data line and storing a voltage provided to a gate of a first transistor of the first circuit; and
> when driving in the discharge mode, providing data from a second data line and storing a voltage provided to the gate of a second transistor of the second circuit.

This provides a voltage driven addressing method in which drive voltages are provided to the first and second data lines.

To implement the sustain mode for this voltage driven approach, the first circuit and the second circuit may each comprise a first transistor and a boost transistor in parallel, wherein the method comprises:

> operating the first transistor and the boost transistor for the charging or discharging mode; and
> operating only the first transistor for the sustain mode.

In a second set of examples the method comprises:

> when driving in the charge mode, using a first current mirror circuit to sample a current provided on a data line; and
> when driving in the discharge mode, using a second current mirror circuit to sample a current provided on the data line,
> wherein selecting a discharge or charge mode comprises selecting the first or second current mirror circuit for mirroring the current sampled from the data line.

BRIEF DESCRIPTION OF THE DRAWINGS

Examples of the invention will now be described in detail with reference to the accompanying schematic drawings, in which:

> Fig. 1A shows a known electroactive unit which is not clamped;
> Fig. 1B shows a known electroactive unit which is constrained by a backing layer;
> Fig. 2 shows a first example of an actuation unit according to one or more embodiments;
> Fig. 3 shows a second example of an actuation unit according to one or more embodiments;
> Fig. 4 shows how to combine multiple of the actuation unit of Fig. 2 or 3 into an array;
> Fig. 5 shows a third example of an actuation unit according to one or more embodiments;
> Fig. 6 shows how to combine multiple ones of the actuation unit of Fig. 5 into an array;
> Fig. 7 shows a modification to the actuation unit of Fig. 3;
> Fig. 8 shows how to combine multiple ones of the actuation unit of Fig. 7 into an array; and
> Fig. 9 shows an actuation method according to one or more embodiments.

DETAILED DESCRIPTION OF THE EMBODIMENTS

The invention provides a device with an actuator unit having an electroactive actuator and a drive unit for driving the electroactive actuator with current in two opposite directions to therewith allow or cause bidirectional actuation or bidirectional switching of actuator.

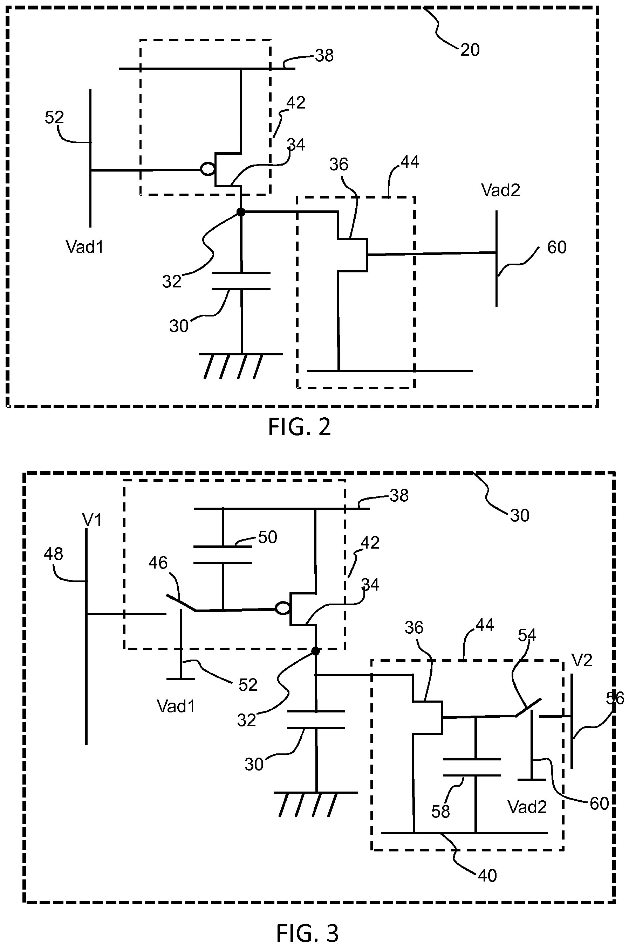

Fig. 2 shows a first example of an actuator unit 20 as part of a device according to one or more of the claims.

The actuation unit comprises an electroactive actuator 30 having at least two electrodes for driving the actuator. For example, the actuator may be of the type of Figs. 1A or 1B or, alternatively, of another type of electroactive actuator. One electrode of the actuator 30 is connected to an electrical reference, which in this case is a ground terminal, and the other electrode is connected to a node 32. The node is at the junction between a first transistor 34 and a second transistor 36 which transistors are in series with each other between a first powerline 38 and a second power line 40. The power lines provide a source or sink of current for driving of the electroactive actuator. These are the lines that provide or sink the current for switching the electroactive actuator or for maintaining its state of actuation.

The first transistor 34 is of p-type and the second transistor 36 is of n-type. This is advantageous with regard to the powerlines and some ways of addressing as described herein below. It is however not necessary and they may be of the same type.

The first transistor channel is connected in series with the electroactive actuator between the first powerline 38 and the electrical reference while the second transistor channel is connected in series with the electroactive actuator between the second powerline 40 and the electrical reference.

Thus, the first transistor 34 is part of a first circuit 42 including the transistor 34 for controlling current through the electroactive actuator 30 in a first direction (e.g. towards the electrical reference) in response to a first addressing signal Vad1 provided to the gate of the first transistor via a first addressing line 52 connected to the gate of the first transistor. Similarly, the second transistor 36 is part of a second circuit 44 for controlling current through the electroactive actuator in a direction opposite to the first direction (e.g. away from the electrical reference) and in response to a second addressing signal Vad2 provided to the gate of the second transistor via a second addressing line 60 connected to the gate of the second transistor.

This configuration enables to use the first and second transistors to control the drive current through the actuator with regard to its direction, magnitude and timing. Also, the combination of first and second circuits enables to select a charge (e.g. using the first circuit) or discharge (e.g. using the second circuit) mode which may be needed for actuators that work on the basis of charge and discharge.

By way of example, the first power line 38 can be at a voltage which is above the maximum voltage to be present at node 32 by a threshold amount and the second power line van be at a voltage which is below the minimum voltage to be present at node 32 by a threshold amount. The power line 38 can be at high voltage and the power line 40 a low voltage. The first and second power lines may for example be at +3V and -3V respectively, or at +5V and -5V respectively. The address lines carrying address signals Vad1 and Vad2 then have voltages of similar orders of magnitude to provide the required switching functionality. These values are given to show the order of magnitude, and to show the low voltage operation of ionic devices compared to high voltage field-driven devices.

When multiple of the actuator units of Fig 2 are part of an array, they may share power lines 38 and 40. However, the address lines 52 and 60 need to be separate as otherwise driving of one actuator may influence another.

Fig. 3 shows an actuator unit 30 which is a variation of the example of Fig. 2. It has the advantage that not only powerlines may be shared between multiple actuator units, but also address lines can be shared. This reduces array complexity. In this example, the first circuit 42 also comprises a first switch 46 between a first data line 48 on which a voltage V1 is provided and the gate of the first transistor 34. The circuit 42 also comprises a first capacitor 50 with one of its plates connected to the gate of the first transistor 34 between the gate and the first switch 46 and its other plate connected to the first power line 38 (this may be another electrical reference if needed). This capacitor can function as a storage capacitor for storing a voltage (in this case the data line voltage VI) provided to the gate of the first transistor. The capacitor 50 stores a gate-source voltage of the transistor 34. The first switch is controlled by a first addressing line 52 on which an address voltage Vad1 is provided.

The second circuit 44 comprises a second switch 54 between a second data line 56 on which a voltage V2 is provided and the gate of the second transistor 36. The second circuit also comprises a storage capacitor 58 with one of its plates connected to the gate of the second transistor 36 between the gate and the second switch 54 and its other plate connected to the second power line 40 (this may be another electrical reference if needed). This capacitor can function for storing a voltage provided to the gate of the second transistor. The capacitor 58 stores the gate-source voltage of the transistor 36. The second switch is controlled by a second addressing line 60 on which a voltage Vad2 is provided.

The switches 46, 54 for example comprise or consist of transistors, with the respective addressing lines 52 and 60 being connected to the transistor gates, and the source and drain connected to the respective data line and to the gate of the respective first/second transistor 34, 36.

Again, as for the example of Fig. 2, and by way of example, the first power line can be at a voltage which is above the maximum voltage to be present at node 32 by a threshold amount and the first power line is at a voltage which is below the minimum voltage to be present at node 32 by a threshold amount. The first and second power lines may be at +3V and -3V or +5V and -5V for example. The addressing lines carrying addressing signals Vad1 and Vad2 then have voltages of similar orders of magnitude to provide the required switching functionality. The data lines may be carrying voltages of the same magnitude. The sign of the voltages may depend on the types of transistors that are used for the first and second transistors. Those skilled in the art will be able to choose what voltages to apply for a type of transistor chosen. The above values are given simply to show the order of magnitude, and to show the low voltage operation of ionic devices compared to high voltage field-driven devices.

The above described actuation units have drive units that makes use of two voltage driven sub-circuits. The first and second address lines 52, 60 comprise or consist of voltage supply conductors. The data lines 48 and 56 also comprise or consist of voltage supply conductors. Each transistor 34, 36 functions as a voltage to current converter, with its gate voltage determining the current flowing. Hence these units may be called voltage addressed current driven units. While in the example of Fig. 2 it is the addressing voltages that determine the current flowing, in the example of Fig. 3 it is the data line voltages that define the flowing current. However, in both examples an electroactive actuator is associated with two addressing lines 52, 60, each line performing the dual role of selecting a unit and its mode of current flow during switching and or maintaining its actuation.

Since in the example shown in Fig 3, the voltages as provided by the data lines to the gate of the transistors during an addressing period can be at least partly stored on the capacitors, the current flow in this unit can be maintained for at least some time even after the addressing signals have been removed. It is noted however, that the capacitors may be omitted as they are not necessary for a basic circuit having the switches 46 and 54.

The operation of the individual first and second circuits of Figs. 3 can be largely equivalent to that known active matrix circuits for driving an LED or OLED device. In the case of the first circuit, it involves programming the gate of the first transistor 34 with a data voltage V1 (using a sample-and-hold addressing approach) the transistor is driven in the mode whereby the current is defined by the gate-source voltage $V_{GS1}$ which is defined by data voltage V1:

$$I = \beta \, (w/l) \, (V_{GS1} - V_{TH})^2$$

where w is the width of the transistor gate, 1 is the length of the transistor gate; $\beta$ is the transistor factor; and $V_{TH}$ is the threshold voltage at which the transistor starts to conduct. The transistor thus functions as a voltage controlled current source.

If present, the function of the storage capacitor is to help maintain a constant voltage at the control terminal of the current source in the period that the circuit is not being addressed. The first circuit can be used to cause the current-driven EAP to actuate in a given direction.

In order to reverse the actuation induced by the first circuit operation, the second circuit 44 is provided into the overall circuit. The second circuit is used to drive current in opposite direction through the electroactive actuator. It operates in the same way as the first circuit. The gate of the transistor 36 is programmed with a data voltage V2 again using a sample-and-hold addressing approach, and the transistor is again driven in the mode whereby the current is defined by the gate-source voltage $V_{GS2}$ which is defined by data voltage V2:

$$I= \beta \, (w/l) \, (V_{GS2}-V_{TH})^2$$

If present, the function of the storage capacitor is again to help maintain a constant voltage at the control terminal of the current source in the period that the circuit is not being addressed. The second circuit is used to cause the current driven actuator to actuate in the opposite direction to the first circuit.

The above circuits or part of the circuits such as transistors may be built in technologies based on semiconductors such as amorphous silicon, low temperature laser crystallized Silicon (LTPS) or other amorphous semiconductors of which Zincoxide based semiconductors such as IndiumGalliumZincOxide (IGZO) are examples. These technologies are known from the display field. Alternatively, plastic electronics technologies may be used. These may be better compatible with electroactive actuators based on electroactive polymers.

The examples above provide a most basic circuit with a single transistor functioning as a current source per switching direction. More complex approaches are possible and may be applied for example for providing compensation for the drift in the threshold voltage of the thin film transistors which may arise during ageing. Such additional compensation measures are for example known in addressing circuits for active matrix (O)LED display pixel addressing schemes as described herein below. Such schemes may be needed if the circuits are built in technologies as provided herein before such as the silicon based ones. For brevity and because they do not alter the way of operating of the novel concept disclosed herein such compensation circuits will not be described.

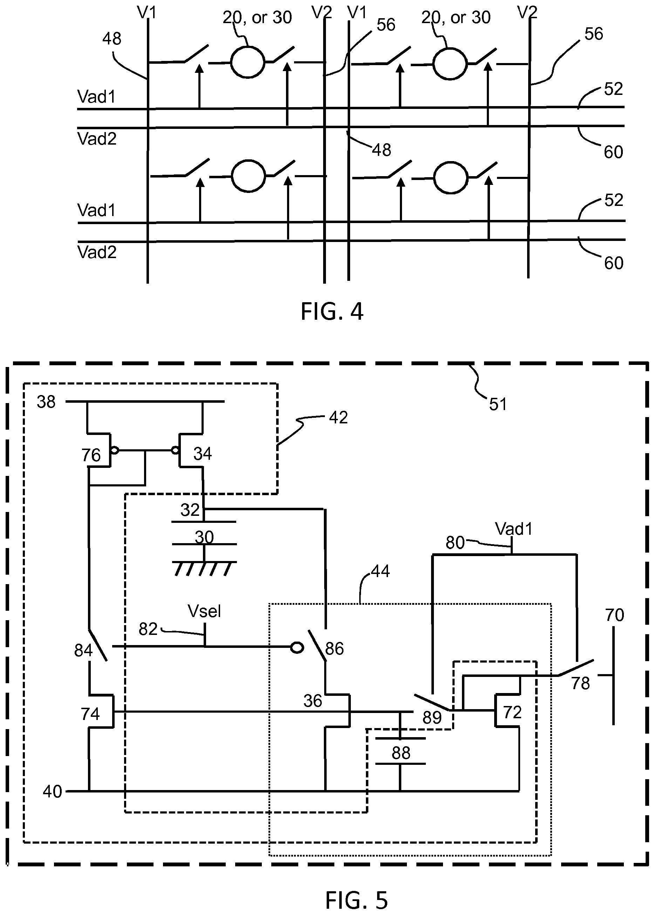

Fig. 4 shows how to combine the multiple ones (a plurality) of actuator units 30 of Fig. 3 into an array such as one of an active matrix array. Each actuator unit 60 is associated with two row addressing lines 52, 60 and two column data lines 48, 56. The first and second addressing lines 52, 60 for example comprise row conductors and the first and second data lines 48, 56 comprise column conductors. It should be noted however that the use of the terms column and row are somewhat arbitrary. Thus, without substantial difference in working principle, the addressing lines may comprise row lines while the data lines may comprise column lines. Thus, in the case of Fig. 4, the first and second circuits each have a row (addressing) line and a column (data) line. The power lines may also be shared by different actuator units for example between those in rows and they thus can also be comprised in column lines. They have not been shown in Fig. 4 for clarity. The reference terminals of the actuator units may be common among many actuators in the array, for example all actuators in an addressing row or indeed all actuators in the array.

Multiple ones of the actuator units 20 of Fig. 2 can also be combined in an array according to Fig.4, such as an active matrix array, with the difference that now the data lines 48 and 56 of represent the addressing lines while the addressing lines 52 and 60 are omitted.

To address the array of actuators, the array is assumed to be initially in a specific actuated state and all rows are initially being supplied with a non-selection voltage (Vns). In this situation, no data can be transferred to the actuators.

The first row of actuators is addressed with a selection voltage applied to both addressing lines 52, 60 and the other rows are not selected (Vns is still applied). If the actuator needs to be switched in one direction (can be charging of the actuator unit), a drive voltage V1 is applied to the first data line 48 to produce the suitable current flowing into the actuator. If the actuator needs to be switched in the other direction (can be discharging of the actuator unit), a drive voltage V2 is applied to the second data line 56 to produce the suitable current flowing out from the actuator. At the end of this period a current will flow into or out from the actuators in the first row, and will be maintained by the storage capacitor.

The second row of actuators is then addressed with a selection voltage applied to both addressing lines and the other rows are not selected (Vns). For each further row, the same process is then followed as for the preceding row until the full array has been addressed and actuated according to need.

At the end of the full addressing phase, all rows can be deselected (with addressing voltage Vns) and voltages can be removed from the columns whereby the actuators will remain in their state of switching until the required end state of actuation is reached, at which point the array may be re-addressed to set only a sustain current (if required) in a manner similar to that described above. The sustain current is used to maintain an achieved state of actuation after a switching current has been provided.

Fig. 5 shows a further example of an actuator unit 51 as part of a novel device.

As for the example of Fig. 3, the actuation unit 51 of Fig. 5 comprises an electroactive actuator 30 with one electrode connected to a reference, such as ground, and the other electrode connected to a node 32. The node is at the junction between a first transistor 34 and a second transistor 36 between a first power line 38 and a second power line 40. The first transistor 34 is part of a first circuit 42 for controlling current through the electroactive actuator 30 in a first direction in response to a first addressing signal during a first addressing period. The second transistor 36 is part of a second circuit 44 for controlling a current through the electroactive polymer actuator in an opposite, second direction (e.g. away from ground) in response to a second addressing signal during a second addressing period.

This unit differs from that in Figs. 2 or 3 in that it is provided with a data current I1 on a data line 70.

The first circuit 42 comprises a first current mirror circuit formed in part by the first transistor 34 and a reference transistor 72. The data current I1 is provided through the reference transistor 72, and it is mirrored by a first mirror transistor 74 and again by another current mirror circuit formed by the combination of a second mirror transistor 76 and the first transistor 34.

The first circuit 44 comprises a second current mirror circuit formed by the second transistor 36 and the reference transistor 72.

A first switch 78 is between the data line 70 and the reference transistor 72 and it is controlled by a first addressing line 80 on which a voltage Vad1 is provided.

A selection circuit is also provided which comprises a further first switch 84 for interrupting the current flow through the first current mirror and a further second switch 86 for interrupting the current flow through the second current mirror circuit. A selection line 82 is provided for carrying a selection voltage Vsel for controlling the further first and second switches. The selection line and voltage thereon can thus be used to control two series switches 84, 86 in complementary manner. The selection circuit is thus for selecting the first or second current mirror for mirroring the current sampled from the data line 70 under control of the second addressing line 82.

The first addressing line 80, the data line 70 and second addressing line 82 may each comprise a separate conductor. For a selected unit (using the addressing line 80), the conductor 82 selects a direction of current flow (which may be charging or discharging of an actuator) and the other column conductor 70 provides the current to be mirrored. Thus, each actuator unit needs only three conductors. In this case, the mode selection and actuator selection are separated, but the two functions are again achieved with two addressing lines.

The first circuit may comprise a storage capacitor 88 for storing a voltage on the gate of the reference transistor 72 in response to a current provided from the data line 70. This provides a current sample and hold function which is shared between the first and second circuits. The advantage of this circuit is that only one addressing current is required for both sinking and sourcing current to actuator 30. Capacitor 88 stores the gate voltage for transistors 36 and 74 and transistor 74 enables the current to be copied into transistor 34 and hence into actuator 30. Having one current driver via data line 70 in the peripheral circuitry is easier to deal with and cheaper than having two with opposite polarities.

The capacitor 88 can be devided in two, one still as capacitor 88 and a new capacitor at the gate of transistor 34. This would need another switch to address it with a voltage, much like in the Fig. 3 circuit. Alternatively the address circuitry on right of the Fig. 5 and implement that for transistor 34 so that transistor 34 can be addressed using current copy i.e. as transistor 36 is addressed. A power save can be realized by adding in a switch and capacitor at the gate of transistor 34, and this would be advantageous, but extra switches would be required to shut the current path between transistors 74 and 76 given that 84 will be closed.

The voltages chosen for the circuit of Fig. 5 will be suitable for the technology used, such as LTPS or types of technology as described hereinabove. The currents chosen will be suitable for the particular type of electroactive actuator.

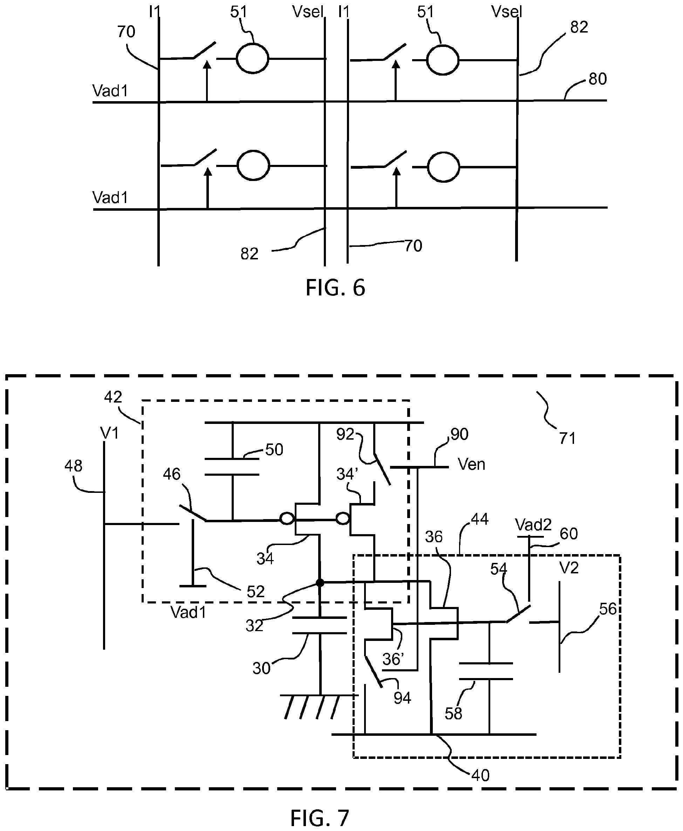

Fig. 6 shows how to combine multiple ones of the actuator unit 51 of Fig. 5 into an array such as an active matrix array. Each unit 51 is associated with one row addressing line and two column lines, one of which is an addressing line and one which is a data line.

The first addressing line 80 may comprise a row conductor and the data line 70 and second addressing line 82 each comprise a column conductor. This may however also be reversed in that the addressing line may comprise or consist of a column conductor while the data line and second addressing line comprise or consist of row conductors.

To address the array of actuators, a similar approach may be followed as above. The array is assumed to be initially in a specific actuated state and all rows are initially being supplied with a non-selection voltage (Vns). In this situation, no data can be transferred to the actuators.

The first row of actuators is addressed with a selection voltage applied to the addressing line 80 and the other rows are not selected (Vns is still applied). For each actuator in the row, a current direction mode (can be charge or discharge mode) is selected using the second addressing line 82. The desired current is applied to the data line 70 from a current driver. After the desired actuation has been reached, the second row of actuators is then addressed with a selection voltage applied to the row addressing line and the other rows are not selected (Vns). The same process is then followed as for the preceding row.

At the end of the full addressing phase, all rows can be deselected (with addressing voltage Vns). The array may be periodically re-addressed to provide only a sustain current if required.

As mentioned above, a sustain current may be needed to maintain a desired actuation state. This may be achieved by periodically re-addressing the array with a suitable current level. Most of the time, the actuators in the array may be in this sustain mode, and it is therefore important that the sustain current can be accurately set at a level required for the state of actuation and maintained.

The sustain currents required are characteristic of the particular electroactive actuator and may even depend on the actuation state. They may be defined in a look up table either provided by the manufacturer or obtained during a product calibration and testing phase.

When switching actuation level, a far higher current is required than needed for the sustain current. It is difficult to provide both an accurate low level sustain current and a significantly higher switching current from a basic current driving circuit.

Fig. 7 shows an actuator unit 71 which is a modification of the actuator unit of Fig. 3 for enabling a high level drive current and a low level sustain current. Delivery of both currents typically is difficult with one type of transistor.

The same reference numbers are used as in Fig. 3 for the same components and a description is not repeated.

The first circuit comprises a first boost transistor 34' which is connected in parallel with the first transistor 34 between the first power line 38 and the node 32. The gates of the first transistor and the first boost transistor are connected. The first circuit also comprises a further first switch 92 for enabling or disabling the current path the first boost transistor provides. In this case the switch 92 is between the powerline 38 and the first boost transistor. It may however also be provided between the gates of the first transistor and the first boost transistor.

The second circuit comprises a second boost transistor 36' which is connected parallel with the second transistor 36, between the second power line 40 and the node 32 with its gate connected to that of the second transistor 36. The second circuit also comprises a further second switch 94 for enabling or disabling the current path the second boost transistor provides. In this case the switch 94 is between the powerline 40 and the second boost transistor. It may however also be provided between the gates of the second transistor and the second boost transistor.

An enable line 90 is provided connecting to the further first and second switches 92 and 94, for enabling or disabling the boost transistors using an enable signal Ven.

A parallel boost transistor when activated means that two currents flow in parallel into or out of the actuator. As a result a higher current is realized. Such a higher current can advantageously be used for the switching current required to change the actuation state of the actuator.

If both of the parallel transistors have the same dimensions the current will be double that provided by the first/second transistor. However in a preferred example, the boost transistor is designed to provide a larger current than the first/second transistor so that the switching current can become much larger. For example, if the boost transistor is five times the size of the first/second transistor, the sum will be six times the current of the first/second transistor only. The most straightforward method of designing a higher current output is by dimensioning the transistor to have a higher width to length ratio which is a matter of layout design. Clearly alternative approaches may be used to adjust any of the other factors in the above transistor current equations.

If an accurate sustain current is needed after switching the smaller one of the parallel transistors may be used while the boost transistor is disabled using the enable/disable signal.

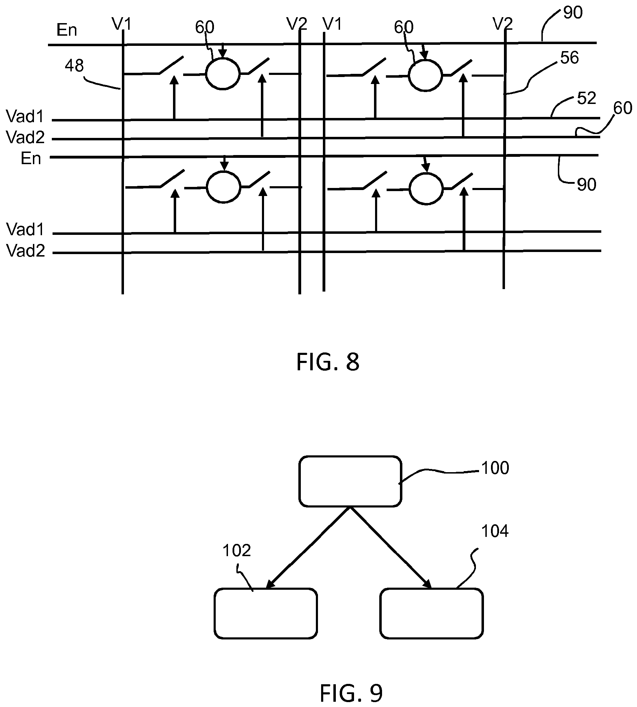

Fig. 8 shows how the additional boost transistors alter the matrix design of Fig.5. It shows that the enable line 90 is provided as an additional row conductor.

During the driving of the actuators to new actuation levels, the enable line is used to provide both parallel transistors in the circuit. Once the actuator array is in its desired actuation state, a periodic readdressing may be performed with the boost transistors disabled, so that a sustain current level is supplied to (or drained from) the actuators using the first or second transistors.

Fig. 9 shows a method of actuating a device which comprises an active matrix array of electroactive actuators. The method comprises, in step 100, using a set of addressing lines to select a group of electroactive actuators in a first direction current mode (this may be a discharge or charge mode) during different addressing periods.

When driving an actuator in the first current direction mode, step 102 comprises using a first circuit to drive a controllable current through the electroactive actuator in a first direction in response to a first addressing signal.

When driving an actuator in the second current direction mode, step 104 comprises using a second circuit to drive a controllable current through the electroactive actuator in an opposite, second direction in response to a second addressing signal.

In all examples, the electroactive actuator comprises an electroactive material structure for providing a mechanical actuation such that the structure defines a non-actuated state and at least one actuated state (different from the non-actuated state) attainable by application of an electrical drive current to the structure. The actuator has an electrode arrangement having at least two electrodes for providing the drive current to the material.

The actuator material of each unit may be sandwiched between the electrodes. Alternatively, electrodes can be on a same side of the material. In either case, electrodes can be physically attached to the material either directly without any (passive) layers in between, or indirectly with additional (passive) layers in between. The electrodes may be stretchable so that they follow the deformation of the electroactive actuator. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

The materials for the different layers will be selected for example taking account of the elastic moduli (Young's moduli) of the different layers.

A 2x2 array has been shown in the Figs. Generally, there is an array of m x n electroactive polymer actuators each driven by an active driving circuit as shown. n≥2 and m≥2, for example n≥4 or n≥10 or n≥50 and/or m≥4 or m≥10 or m≥50.

The circuits above are based on the use of transistors, and the switches may also be transistors. The transistors are preferably made as thin film transistors in for example amorphous silicon or IGZO or polysilicon technology.

Materials suitable for the electroactive actuators are known. They may be of inorganic nature or of organic nature. Preferably they are of organic nature as this provides facile design options. The electroactive materials preferably are of the polymeric type so that the electroactive actuators are electroactive polymer actuators.

Electroactive polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

Ionic EAPs (which are the subject of this invention) are activated by an electrically induced transport of ions and/or solvent within a transport medium. They usually require low voltages but high currents. The medium may comprise a liquid/gel electrolyte medium (although some material systems can also operate using solid electrolytes in the form of e.g. polyemers).

These devices may operate with a large hysteresis loop. A large injection of current is needed to move around the hysteresis loop and thus change the actuation state, and a small sustain current is needed to retain a level of actuation. The sustain current may also be needed.

A first notable subclass of ionic EAPs is Ionic Polymer Metal Composites (IPMCs). IPMCs consist of a solvent swollen ion-exchange polymer membrane laminated between two thin metal or carbon based electrodes and requires the use of an electrolyte. Typical electrode materials are Pt, Gd, CNTs, CPs, Pd. Typical electrolytes are Li+ and Na+ water-based solutions. When a field is applied, cations typically travel to the cathode side together with water. This leads to reorganization of hydrophilic clusters and to polymer expansion. Strain in the cathode area leads to stress in rest of the polymer matrix resulting in bending towards the anode. Reversing the applied voltage inverts bending. Well known polymer membranes are Nafion® and Flemion®.

Another notable subclass of Ionic polymers is conjugated/conducting polymers. A conjugated polymer actuator typically consists of an electrolyte sandwiched by two layers of the conjugated polymer. The electrolyte is used to change oxidation state. When a potential is applied to the polymer through the electrolyte, electrons are added to or removed from the polymer, driving oxidation and reduction. Reduction results in contraction, oxidation in expansion.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrrole (PPy), Polyaniline (PANi) and polythiophene (PTh).

The strain induced in the device is for example proportional to charge (and hence the strain rate is proportional to current). This is for example the case for polypyrrole. This linear relationship between strain and charge is valid over a large frequency range up to 1Hz. A simple model representing the electrical behavior is a large capacitor with a parallel resistor, in series with another resistor.

If the plated electrodes are arranged in a non-symmetric configuration, the imposed voltage can induce all kinds of deformations such as twisting, rolling, torsioning, turning, and non-symmetric bending deformation.

The device as defined by the claims can be applied in a variety of applications.

In many applications the main function of the product relies on the (local) manipulation of human tissue, or the actuation of tissue contacting interfaces. In such applications actuators and especially the ones of organic type provide unique benefits mainly because of the small form factor, the flexibility and the high energy density. Hence they can be easily integrated in soft, 3D-shaped and / or miniature products and interfaces. Examples of such applications are:

Skin cosmetic treatments such as skin actuation devices in the form of skin patches which apply a constant or cyclic stretch to the skin in order to tension the skin or to reduce wrinkles;

Respiratory devices with a patient interface mask which has an actuator actuated active cushion or seal, to provide an alternating normal pressure to the skin which reduces or prevents facial red marks;

Electric shavers with an adaptive shaving head. The height of the skin contacting surfaces can be adjusted using actuators in order to influence the balance between closeness and irritation;

Oral cleaning devices such as an air floss with a dynamic nozzle actuator to improve the reach of the spray, especially in the spaces between the teeth. Alternatively, toothbrushes may be provided with activated tufts;

Consumer electronics devices or touch panels which provide local haptic feedback via an array of transducers which is integrated in or near the user interface;

Catheters with a steerable tip to enable easy navigation in tortuous blood vessels.

Another category of relevant application which benefits from actuators relates to the modification of light. Optical elements such as lenses, reflective surfaces, gratings etc. can be made adaptive by shape or position adaptation using actuators. Here the benefits of actuators are for example the lower power consumption.

Note that the terms "row" and "column" are somewhat arbitrary and are merely used to denote orthogonal lines. Thus, while a row is generally considered to run from left to right and a column is generally considered to run from top to bottom, this does not exclude that a row may run up and down and a column run left to right if a device is rotationally oriented in a particular way. Thus "row" and "column" are merely used for ease of the reader and could be considered equivalent to "a first vector direction" and "a second, orthogonal, vector direction".

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

In summary the device as defined by the claims comprises electroactive polymer actuators each of which is addressed by two addressing lines for selecting the electroactive polymer actuator and a current direction drive mode. A first circuit is for driving a controllable current through the electroactive actuator in a first direction and a second circuit is for driving a controllable current through the electroactive actuator in a second direction, opposite to the first direction. This device enables an actuator to be driven with current in two opposite directions so that the actuator may be driven bidirectionally between actuation states.

**Claims**

1. A device comprising an actuator unit, the actuator unit comprising:

    - an electroactive actuator (30) for current-addressed actuation;
    - a driving circuit for current-addressed actuation of the electroactive actuator, the driving circuit comprising:

        - a first control line (52, 80) and a second control line (60, 82) for controlling the actuator unit;
        - a first circuit (42) comprising a first transistor (34) for driving a current through the electroactive actuator in a first direction, the gate of the first transistor being associated with the first control line; and
        - a second circuit (44) comprising a second transistor (36) for driving a current through the electroactive actuator in a second direction opposite to the first direction, the gate of the second transistor being associated with the second control line.

2. A device as claimed in claim 1, wherein the channels of the first transistor (34) and of the second transistor (36) are in series between a first and a second power line (38, 40), and the electroactive polymer actuator is connected to a junction (32) between the channels of the first transistor and of the second transistor.

3. A device as claimed in claim 1 or 2, wherein:

    - the first control line comprises a first data line (48) and a first addressing line (52) and the second control line comprises a second data line (56) and a second addressing line (60);
    - the first circuit (42) comprises:

        - a first switch (46) between the first data line and the gate of the first transistor and the first switch is configured to be controlled by the first addressing line, and

    the second circuit (44) comprises:

        - a second switch (54) between a second data line (56) and the gate of the second transistor, the second switch (54) being controlled by the second addressing line (60), and

4. A device as claimed in claim 2 or 3, wherein:

    - the first circuit (42) comprises:
    - a first capacitor (50) for storing a voltage provided to the gate of the first transistor; and

    the second circuit (44) comprises:

        - a second capacitor (58) for storing a voltage provided to the gate of the second transistor.

**5.** A device as claimed in claim 3 or 4, wherein:

- the first circuit comprises a first boost transistor (34') with its channel in parallel with the first transistor (34) and with its gate connected to a first enable line (90) for controlling the second boost transistor; and
- the second circuit comprises a second boost transistor (36') with its channel connected in parallel with the second transistor (36), the gate of which is connected to a second enable line (90) for controlling the second boost transistor.

**6.** A device as claimed in claim 2, wherein:

- the first circuit (42) comprises a first current mirror circuit comprising the first transistor (34) and a first reference transistor (72);
- the second circuit (44) comprises a second current mirror circuit comprising the second transistor (36) and a second reference transistor (72); and
- the first control line comprises a first addressing line (80) and data line (70); wherein the driving circuit further comprises:

   - a third switch (78) between the data line (70) and the reference transistor (72) and a fourth switch 89 between the gate of the reference transistor and the gate of the second transistor 36, the third switch and the fourth switch being controlled by the first addressing line (80); and
   - a selection circuit (84, 86) for selecting the first current mirror or the second current mirror circuit for mirroring a current sampled from the data line, under the control of the second control line (82).

**7.** A device as claimed in claim 6, wherein the data line comprises a current supply conductor.

**8.** A device as claimed in claim 6 or 7, wherein the switching circuit comprises a storage capacitor (88) for storing a voltage on the gate of the reference transistor (72) in response to a current provided from the data line.

**9.** A device as claimed in any one of the previous claims, comprising a plurality of the actuator units, the plurality of actuator units sharing the power lines.

**10.** A device as claimed in any one of claims 3 to 9, wherein the plurality of actuator units share their first control lines and their second control lines.

**11.** A device as claimed in claim 10, wherein the plurality of actuator units is arranged in a matrix array with rows and columns and any first and/or second addressing lines are along the row direction and any data lines and/or power lines are along the column direction.

**12.** A device as claimed in any preceding claim, wherein the driving circuit comprises thin film transistors such as with a semiconductor channel made of one or more of the following: IGZO, amorphous silicon and polycrystalline silicon.

**13.** A method of actuating a device which comprises a current-driven electroactive polymer actuator unit, wherein the method comprises:

   (100) using a first and second control line to select a driving mode for the actuator unit during different periods;
   (102) when driving an actuator in a first drive mode, using a first circuit to drive a controllable current through the electroactive polymer actuator in a first direction in response to a control signal; and
   (104) when driving an actuator in a second drive mode, using a second circuit to drive a controllable current through the electroactive polymer actuator in an opposite, second direction in response to a second control signal.

**14.** A method as claimed in claim 13, further comprising operating the actuator in a sustain mode wherein a smaller current is provided than in the first drive mode or the second drive mode in order to sustain an actuation level.

**15.** A method as claimed in claim 13 or 14, wherein:

   when driving in the first drive mode, using a first current mirror circuit to sample a current provided on a data line; and
   when driving in the second drive mode mode, using a second current mirror circuit to sample a current provided on the data line, wherein selecting the first or second drive mode mode comprises selecting the first or second current mirror circuit for mirroring the current sampled from the data line.

**Patentansprüche**

**1.** Ein Gerät mit einer Aktoreinheit, wobei die Aktoreinheit Folgendes umfasst:

   - einen elektroaktiven Aktor (30) für die stromadressierte Betätigung;
   - ein Steuerkreis für die stromadressierte Betätigung des elektroaktiven Aktors, wobei der Steuerkreis Folgendes umfasst:

- eine erste Steuerleitung (52, 80) und eine zweite Steuerleitung (60, 82) zum Steuern der Aktoreinheit;
- eine erste Schaltung (42) mit einem ersten Transistor (34) zum Leiten von Strom durch den elektroaktiven Aktor in einer ersten Richtung, wobei der Steueranschluss des ersten Transistors mit der ersten Steuerleitung verbunden ist; und
- eine zweite Schaltung (44) mit einem zweiten Transistor (36) zum Leiten von Strom durch den elektroaktiven Aktor in einer zweiten, der ersten Richtung entgegengesetzten Richtung, wobei der Steueranschluss des zweiten Transistors mit der zweiten Steuerleitung verbunden ist.

2. Ein Gerät gemäß Anspruch 1, wobei die Kanäle des ersten Transistors (34) und des zweiten Transistors (36) zwischen einer ersten und einer zweiten Stromleitung (38, 40) in Reihe geschaltet sind, und wobei der elektroaktive Polymeraktor über eine Verzweigung (32) zwischen den Kanälen des ersten Transistors und des zweiten Transistors verbunden ist.

3. Ein Gerät gemäß Anspruch 1 oder 2, wobei:

- die erste Steuerleitung eine erste Datenleitung (48) und eine erste Adressierungsleitung (52) umfasst, und wobei die zweite Steuerleitung eine zweite Datenleitung (56) und eine zweite Adressierungsleitung (60) umfasst;
- die erste Schaltung (42) Folgendes umfasst:

- einen ersten Schalter (46) zwischen der ersten Datenleitung und dem Steueranschluss des ersten Transistors, und wobei der erste Schalter von der ersten Adressierungsleitung gesteuert wird, und

die zweite Schaltung (44) Folgendes umfasst:

- einen zweiten Schalter (54) zwischen einer zweiten Datenleitung (56) und dem Steueranschluss des zweiten Transistors, und wobei der zweite Schalter (54) von der zweiten Adressierungsleitung (60) gesteuert wird, und

4. Ein Gerät gemäß Anspruch 2 oder 3, wobei:

- die erste Schaltung (42) Folgendes umfasst:
- einen ersten Kondensator (50) zum Speichern der dem Steueranschluss des ersten Transistors zugeführten Spannung; und

die zweite Schaltung (44) Folgendes umfasst:

- einen zweiten Kondensator (58) zum Speichern der dem Steueranschluss des zweiten Transistors zugeführten Spannung.

5. Ein Gerät gemäß Anspruch 3 oder 4, wobei:

- die erste Schaltung einen ersten Antriebstransistor (34') umfasst, dessen Kanal parallel zum ersten Transistor (34) verläuft und dessen Steueranschluss zum Steuern des zweiten Antriebstransistors mit einer ersten Aktivierungsleitung (90) verbunden ist; und
- die zweite Schaltung einen zweiten Antriebstransistor (36') umfasst, dessen Kanal parallel zum zweiten Transistor (36) geschaltet ist und dessen Steueranschluss zum Steuern des zweiten Antriebstransistors mit einer zweiten Aktivierungsleitung (90) verbunden ist; und

6. Ein Gerät gemäß Anspruch 2, wobei:

- die erste Schaltung (42) eine erste Stromspiegelschaltung umfasst, die den ersten Transistor (34) und einen ersten Referenztransistor (72) umfasst;
- die zweite Schaltung (44) eine zweite Stromspiegelschaltung umfasst, die den zweiten Transistor (36) und einen zweiten Referenztransistor (72) umfasst; und
- die erste Steuerleitung eine erste Adressierungsleitung (80) und eine Datenleitung (70) umfasst;

wobei die Antriebsleitung zudem Folgendes umfasst:

- einen dritten Schalter (78) zwischen der Datenleitung (70) und dem Referenztransistor (72) und einen vierten Schalter 89 zwischen dem Steueranschluss des Referenztransistors und dem Steueranschluss des zweiten Transistors (36), wobei der dritte Schalter und der vierte Schalter von der ersten Adressierungsleitung (80) gesteuert werden; und
- eine Auswahlschaltung (84, 86) zum Auswählen des ersten Stromspiegels oder der zweiten Stromspiegelschaltung zum Spiegeln des von der Datenleitung abgetasteten Stroms beim Steuern der zweiten Steuerleitung (82).

7. Ein Gerät gemäß Anspruch 6, wobei die Datenleitung einen Stromversorgungsleiter umfasst.

8. Ein Gerät gemäß Anspruch 6 oder 7, wobei der Schaltkreis einen Speicherkondensator (88) zum Speichern der Spannung am Steueranschluss des Referenztransistors (72), wenn die Datenleitung Strom bereitstellt.

9. Ein Gerät gemäß einem der vorherigen Ansprüche, das mehrere Aktoreinheiten umfasst, die sich die Stromleitungen teilen.

10. Ein Gerät gemäß einem der Ansprüche 3 bis 9, wobei sich die Aktoreinheiten die ersten Steuerleitungen und die zweiten Steuerleitungen teilen.

11. Ein Gerät gemäß Anspruch 10, wobei die Aktoreinheiten in einem Matrix-Array mit Zeilen und Spalten angeordnet sind, und wobei jegliche erste und/oder zweite Adressierungsleitungen entlang der Zeilenrichtung und jegliche Datenleitungen und/oder Stromleitungen entlang der Spaltenrichtung verlaufen.

12. Ein Gerät gemäß einem der vorhergehenden Ansprüche, wobei der Steuerkreis Dünnschichttransistoren umfasst, z. B. mit einem Halbleiterkanal aus einem oder mehreren der folgenden Materialien: IGZO, amorphes Silizium und polykristallines Silizium.

13. Eine Methode zum Betätigen eines Geräts, das eine strombetriebene elektroaktive Polymer-Aktoreinheit umfasst, wobei die Methode folgende Schritte umfasst:

(100) Verwenden einer ersten und zweiten Steuerleitung, um in verschiedenen Phasen einen Antriebsmodus für die Aktoreinheit auszuwählen;
(102) wenn ein Aktor in einem ersten Steuermodus betrieben wird, Verwenden einer ersten Schaltung zum Leiten eines regelbaren Stroms durch den elektroaktiven Polymeraktor in einer ersten Richtung als Reaktion auf ein Steuersignal; und
(104) wenn ein Aktor in einem zweiten Steuermodus betrieben wird, Verwenden einer zweiten Schaltung zum Leiten eines regelbaren Stroms durch den elektroaktiven Polymeraktor in einer zweiten, der ersten Richtung entgegengesetzten Richtung als Reaktion auf ein zweites Steuersignal.

14. Eine Methode gemäß Anspruch 13, die zudem das Betreiben des Aktors in einem Erhaltungsmodus umfasst, wobei ein kleinerer Strom als im ersten Steuermodus oder im zweiten Steuermodus bereitgestellt wird, um den Betätigungspegel aufrechtzuerhalten.

15. Eine Methode gemäß Anspruch 13 oder 14, wobei:

beim Ansteuern im ersten Steuermodus eine erste Stromspiegelschaltung verwendet wird, um den für eine Datenleitung bereitgestellten Strom abzutasten; und

beim Ansteuern im zweiten Steuermodus eine zweite Stromspiegelschaltung verwendet wird, um den für die Datenleitung bereitgestellten Strom abzutasten; und

wobei das Auswählen des ersten oder zweiten Steuermodus das Auswählen der ersten oder zweiten Stromspiegelschaltung zum Spiegeln des von der Datenleitung abgetasteten Stroms umfasst.

**Revendications**

1. Dispositif comprenant une l'unité d'actionneur, l'unité d'actionneur comprenant :

- un actionneur (30) électroactif destiné à l'actionnement adressé en courant ;
- un circuit d'attaque destiné à l'actionnement adressé en courant de l'actionneur électroactif, le circuit d'attaque comprenant :

- une première ligne de commande (52, 80) et une seconde ligne de commande (60, 82) destinées à la commande de l'unité d'actionneur ;
- un premier circuit (42) comprenant un premier transistor (34) destiné à l'attaque d'un courant à travers l'actionneur électroactif dans une première direction, la grille du premier transistor étant associée à la première ligne de commande ; et
- un second circuit (44) comprenant un second transistor (36) destiné à l'attaque d'un courant à travers l'actionneur électroactif dans une seconde direction, opposée à la première direction, la grille du second transistor étant associée à la seconde ligne de commande.

2. Dispositif selon la revendication 1, dans lequel les canaux du premier transistor (34) et du second transistor (36) sont connectés en série entre une première et une seconde ligne électrique (38, 40), et l'actionneur polymère électroactif est connecté à une jonction (32) entre les canaux du premier transistor et du second transistor.

3. Dispositif selon la revendication 1 ou 2, dans lequel :

- la première ligne de commande comprend une première ligne de données (48) et une première ligne d'adressage (52) et la seconde ligne de commande comprend une seconde ligne de données (56) et une seconde ligne d'adressage (60) ;
- le premier circuit (42) comprend :

- un premier interrupteur (46) entre la première ligne de données et la grille du premier transistor et le premier interrupteur est conçu pour être commandé par la première ligne d'adressage, et

le second circuit (44) comprend :

- un deuxième interrupteur (54) entre une seconde ligne de données (56) et la grille du second transistor, le deuxième interrupteur (54) étant commandé par la seconde ligne d'adressage (60), et

4. Dispositif selon la revendication 2 ou 3, dans lequel :

- le premier circuit (42) comprend :
- un premier condensateur (50) destiné au stockage d'une tension fournie à la grille du premier transistor ; et

le second circuit (44) comprend :

- un second condensateur (58) destiné au stockage d'une tension fournie à la grille du second transistor.

5. Dispositif selon la revendication 3 ou 4, dans lequel :

- le premier circuit comprend un premier transistor élévateur (34') dont le canal est connecté en parallèle au premier transistor (34) et la grille est connectée à une première ligne de validation (90) pour commander le second transistor élévateur ; et
- le second circuit comprend un second transistor élévateur (36') dont le canal est connecté en parallèle au second transistor (36) et la grille est connectée à une seconde ligne de validation (90) pour commander le second transistor élévateur.

6. Dispositif selon la revendication 2, dans lequel :

- le premier circuit (42) comprend un premier circuit miroir de courant comprenant le premier transistor (34) et un premier transistor de référence (72) ;
- le second circuit (44) comprend un second circuit miroir de courant comprenant le second transistor (36) et un second transistor de référence (72) ; et
- la première ligne de commande comprend une première ligne d'adressage (80) et une ligne de données (70) ;

dans lequel le circuit de commande comprend en outre :

- un troisième interrupteur (78) entre la ligne de données (70) et le transistor de référence (72) et un quatrième interrupteur (89) entre la grille du transistor de référence et la grille du second transistor (36), le troisième interrupteur et le quatrième interrupteur étant commandés par la première ligne d'adressage (80) ; et
- un circuit de sélection (84, 86) destiné à la sélection du premier miroir de courant ou le second circuit miroir de courant pour refléter un courant échantillonné à partir de la ligne de données, sous la commande de la seconde ligne de commande (82).

7. Dispositif selon la revendication 6, dans lequel la ligne de données comprend un conducteur d'alimentation en courant.

8. Dispositif selon la revendication 6 ou 7, dans lequel le circuit de commutation comprend un condensateur de stockage (88) destiné au stockage d'une tension sur la grille du transistor de référence (72) en réponse à un courant fourni par la ligne de données.

9. Dispositif selon l'une quelconque des revendications précédentes, comprenant une pluralité d'unités d'actionneur, la pluralité d'unités d'actionneur partageant les lignes électriques.

10. Dispositif selon l'une quelconque des revendications 3 à 9, dans lequel la pluralité d'unités d'actionneur partagent leurs premières lignes de commande et leurs secondes lignes de commande.

11. Dispositif selon la revendication 10, dans lequel la pluralité d'unités d'actionneur est agencée dans un réseau matriciel comportant des rangées et des colonnes et toutes les premières et/ou secondes lignes d'adressage sont positionnées le long de la direction des rangées et toutes les lignes de données et/ou lignes d'alimentation sont positionnées le long de la direction des colonnes.

12. Dispositif selon l'une quelconque des revendications précédentes, dans lequel le circuit de commande comprend des transistors à couche mince tels que comportant un canal semi-conducteur constitué d'éléments suivants : IGZO, silicium amorphe et/ou silicium polycristallin.

13. Procédé d'actionnement d'un dispositif, lequel comprend une unité d'actionneur en polymère électroactif commandée par courant, dans lequel le procédé comprend :

(100) l'utilisation d'une première et d'une seconde ligne de commande pour sélectionner un mode d'attaque pour l'unité d'actionneur pendant différentes périodes ;

(102) lors de l'attaque d'un actionneur dans un premier mode d'attaque, à l'aide d'un premier circuit pour attaquer un courant pouvant être commandé à travers l'actionneur polymère électroactif dans une première direction en réponse à un signal de commande ; et

(104) lors de l'attaque d'un actionneur dans un second mode d'attaque, à l'aide d'un premier circuit pour attaquer un courant pouvant être commandé à travers l'actionneur polymère électroactif dans une seconde direction opposée en réponse à un second signal de commande.

**14.** Procédé selon la revendication 13, comprenant en outre le fonctionnement de l'actionneur dans un mode de maintien, dans lequel un courant plus faible est fourni que dans le premier mode d'attaque ou le second mode d'attaque afin de maintenir un niveau d'actionnement.

**15.** Procédé selon la revendication 13 ou 14, dans lequel :

lors de l'attaque dans le premier mode d'attaque, un premier circuit miroir de courant est utilisé pour échantillonner un courant fourni sur une ligne de données ; et

lors de l'attaque dans le second mode d'attaque, un second circuit miroir de courant est utilisé pour échantillonner un courant fourni sur la ligne de données,

dans lequel la sélection du premier ou du second mode d'attaque comprend la sélection du premier ou du second circuit miroir de courant pour refléter le courant échantillonné à partir de la ligne de données.

12
14
10

**FIG. 1A**

12
14
10
16

10,12,14
16

**FIG. 1B**

FIG. 2

FIG. 3

FIG. 4

FIG. 5

FIG. 6

FIG. 7

FIG. 8

FIG. 9

**REFERENCES CITED IN THE DESCRIPTION**

**Patent documents cited in the description**

- WO 2017108489 A
- WO 2017108443 A
- JP 2015204702 A
- WO 2015045605 A